# DEMANDE DE BREVET EUROPEEN

(11) **EP 1 724 823 A2**
(43) Date de publication de la demande: **22.11.2006**
(21) Numéro de dépôt: 06008244.3
(22) Date de dépôt: 21.04.2006
(51) Int. Cl.: H01L 21/60

(54) **Procédé de connexion d'une microplaquette de semi-conducteur sur un support d'interconnexion**

(30) Priorité: 11.05.2005 FR 0504700
(71) Demandeur: STMICROELECTRONICS SA, 92120 Montrouge (FR)
(72) Inventeur: Steffen, Francis, 83470 Saint Maximin (FR)
(74) Mandataire: Marchand, André

(57) **Abrégé**

L'invention concerne un procédé de connexion électrique d'une microplaquette (10) de semi-conducteur avec un support d'interconnexion (20), la microplaquette comprenant des plages de contact (12), le support d'interconnexion (20) comprenant un substrat (21) et des plages de réception (22). Selon l'invention, le procédé comprend une étape de croissance d'une première couche de métal (50) sur les plages de contact (12) de la microplaquette et une étape de croissance d'une seconde couche de métal (51) sur les plages de réception (22) du support d'interconnexion, par dépôt électrolytique de métal, jusqu'à ce que la première et la seconde couches de métal se rejoignent et forment un contact électrique reliant les plages de contact de la microplaquette et les plages de réception du support d'interconnexion. Application à la réalisation de cartes électroniques et de modules électroniques.

## Description

La présente invention concerne la fabrication de modules électroniques ou de cartes électroniques sur substrats souples ou rigides.

La présente invention concerne plus particulièrement un procédé de connexion électrique d'une microplaquette de semi-conducteur avec un support d'interconnexion, la microplaquette comprenant des plages de contact, le support d'interconnexion comprenant un substrat et des plages de réception.

Un circuit intégré se présente classiquement sous la forme d'une microplaquette de silicium qui comporte une face active sur laquelle est implantée une région de circuit intégré, formant le circuit intégré proprement dit, et des plages de contact reliées électriquement à la région de circuit intégré. Dans les applications où un haut degré d'intégration est souhaité, les microplaquettes de silicium sont généralement montées nues sur leurs supports d'interconnexion, sans être préalablement disposées dans des boîtiers de protection. Dans ce cas, la connexion électrique des plages de contact des microplaquettes avec des plages de réception du support d'interconnexion peut être réalisée par câblage ultrasonique ou au moyen de la technique "flip-chip" ("puce retournée").

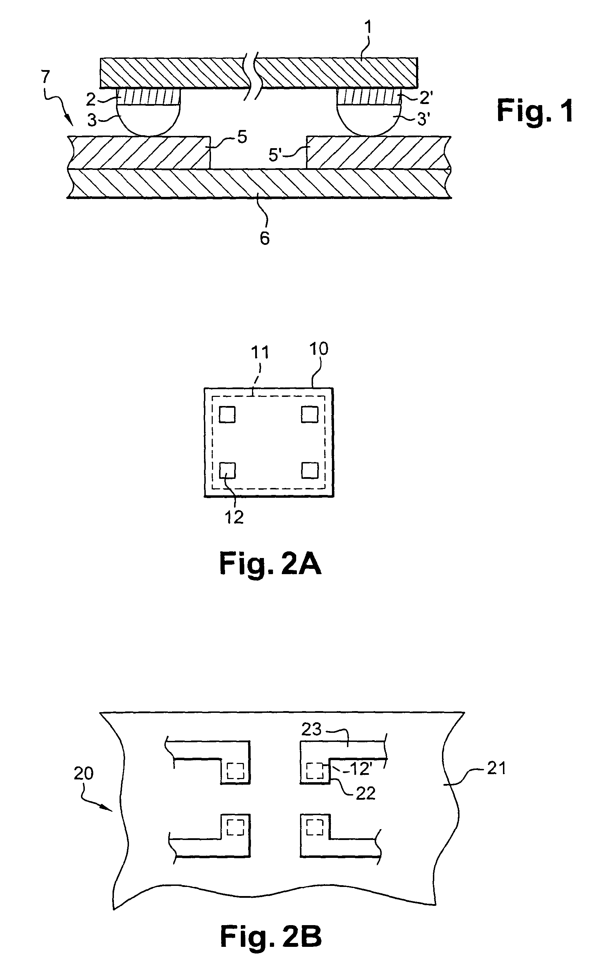

Le montage d'une microplaquette selon la technique flip-chip est illustré schématiquement en figure 1. On distingue sur cette figure une microplaquette de silicium 1 et deux plages de contact 2, 2' de la microplaquette, vues en coupe. Les plages de contact 2, 2' sont recouvertes par un matériau de connexion formant une excroissance 3, 3' ("bump") sur la face active de la microplaquette. Le matériau de connexion est par exemple un eutectique étain-plomb ou étain-argent-cuivre, un polymère conducteur à charge métallique, ou encore un métal déposé sur la microplaquette par voie électrolytique, par exemple du cuivre, du nickel ou de l'or.

La microplaquette est agencée à l'envers, face active orientée vers le bas, sur un support d'interconnexion 7. Le support d'interconnexion 7 comprend un substrat 6 et des plages de réception 5, 5' solidaires du substrat, et les plages de contact 2, 2' de la microplaquette sont disposées sur les plages de réception 5, 5'. L'assemblage et la connexion de la microplaquette 1 sur le support d'interconnexion 7 est assuré par fusion des excroissances 3, 3' en présence d'une source de chaleur, ou par fluage des excroissances 3, 3', en appliquant à la microplaquette une énergie mécanique, les techniques les plus couramment utilisées étant le fluage par compression ou par application de vibrations ultrasoniques.

Cette méthode d'assemblage et de connexion comprend de nombreuses variantes technologiques mais présente l'inconvénient général de nécessiter une étape préalable de réalisation des excroissances 3, 3' sur la microplaquette, en préparation de l'étape de connexion proprement dite.

La présente invention vise une méthode d'assemblage et de connexion d'une microplaquette sur un support d'interconnexion formant une alternative à cette méthode classique.

La présente invention se base sur la constatation que, dans l'industrie, les techniques de dépôt électrolytique de métal sont appliquées aussi bien aux microplaquettes de silicium, pour former les excroissances de connexion flip-chip, qu'aux supports d'interconnexion eux-mêmes, pour former des pistes et des plages conductrices.

Ainsi, une idée de la présente invention est de créer une connexion électrique entre une plage de contact d'une microplaquette de silicium et une plage de réception d'un support d'interconnexion, en faisant croître une première couche de métal sur la plage de contact et une seconde couche de métal sur la plage de réception jusqu'à ce que les deux couches de métal se rejoignent.

Plus particulièrement, la présente invention prévoit un procédé de connexion électrique d'une microplaquette de semi-conducteur avec un support d'interconnexion, la microplaquette comprenant des plages de contact, le support d'interconnexion comprenant un substrat et des plages de réception, le procédé comprenant une étape de croissance d'une première couche de métal sur les plages de contact de la microplaquette et une étape de croissance d'une seconde couche de métal sur les plages de réception du support d'interconnexion, par dépôt électrolytique de métal, jusqu'à ce que la première et la seconde couches de métal se rejoignent et forment un contact électrique reliant les plages de contact de la microplaquette et les plages de réception du support d'interconnexion.

De préférence, l'étape de croissance de la première couche de métal et l'étape de croissance de la seconde couche de métal sont conduites simultanément.

Selon un mode de réalisation, le procédé comprend les étapes suivantes : appliquer aux plages de contact de la microplaquette un traitement les rendant compatibles avec le dépôt électrolytique de métal, et former les plages de réception du support d'interconnexion avec un matériau compatible avec le dépôt électrolytique de métal ou appliquer aux plages de réception un traitement les rendant compatibles avec le dépôt électrolytique de métal.

Selon un mode de réalisation, les couches de métal formées par dépôt électrolytique sont en un matériau compris dans le groupe comprenant le cuivre, le nickel et l'or.

Selon un mode de réalisation, avant le dépôt électrolytique de métal, les plages de réception du support d'interconnexion comprennent seulement une trace d'un matériau compatible avec le dépôt électrolytique de métal, et les plages de réception ne sont entièrement formées qu'après croissance de la seconde couche de métal.

Selon un mode de réalisation, le support d'interconnexion comprend des pistes conductrices dans le prolongement des plages de réception, et dans lequel, avant le dépôt électrolytique de métal, les pistes conductrices comprennent seulement une trace d'un matériau compatible avec le dépôt électrolytique de métal, et ne sont entièrement formées qu'après croissance de la seconde couche de métal.

Selon un mode de réalisation, la trace de matériau compatible avec le dépôt électrolytique de métal comprend un matériau polymère.

Selon un mode de réalisation, les plages de réception du support d'interconnexion et les plages de contact de la microplaquette sont portées à un potentiel électrique non nul pendant le dépôt électrolytique de métal.

Selon un mode de réalisation, pendant le dépôt électrolytique de métal les plages de contact de la microplaquette sont portées à un potentiel électrique en appliquant le potentiel électrique à un substrat semi-conducteur de la microplaquette et en utilisant des jonctions PN antistatiques reliant les plages de contact au substrat semi-conducteur pour propager le potentiel électrique jusqu'aux plages de contact.

Selon un mode de réalisation, le procédé comprend une étape consistant à prévoir dans la microplaquette des plages de contact qui sont dépourvues de jonction antistatique et sont isolées du substrat semi-conducteur par un caisson de matériau électriquement isolant, de sorte qu'aucun dépôt de métal d'épaisseur significative ne se produit sur de telles plages de contact pendant le dépôt électrolytique de métal.

Selon un mode de réalisation, pendant le dépôt électrolytique de métal la microplaquette est maintenue sur le support d'interconnexion par une couche de matériau isolant qui ne recouvre pas les plages de contact de la microplaquette devant recevoir la première couche de métal.

Ces objets, caractéristiques et avantages ainsi que d'autres de la présente invention seront exposés plus en détail dans la description suivante du procédé selon l'invention, faite à titre non limitatif en relation avec les figures jointes parmi lesquelles :
- la figure 1 précédemment décrite illustre un procédé classique d'assemblage et de connexion d'une microplaquette à un support d'interconnexion selon la technique flip-chip,
- les figures 2A, 2B représentent respectivement, par des vues de dessus, une microplaquette de silicium et un support d'interconnexion avant assemblage et connexion de la microplaquette sur le support d'interconnexion selon le procédé de l'invention,
- la figure 3A est une vue en coupe qui illustre une étape du procédé selon l'invention à un stade de développement intermédiaire,
- la figure 3B illustre l'étape de la figure 3A à un stade de développement avancé ou final, et
- la figure 4 est une vue en coupe schématique de la microplaquette et illustre un aspect du procédé de l'invention.

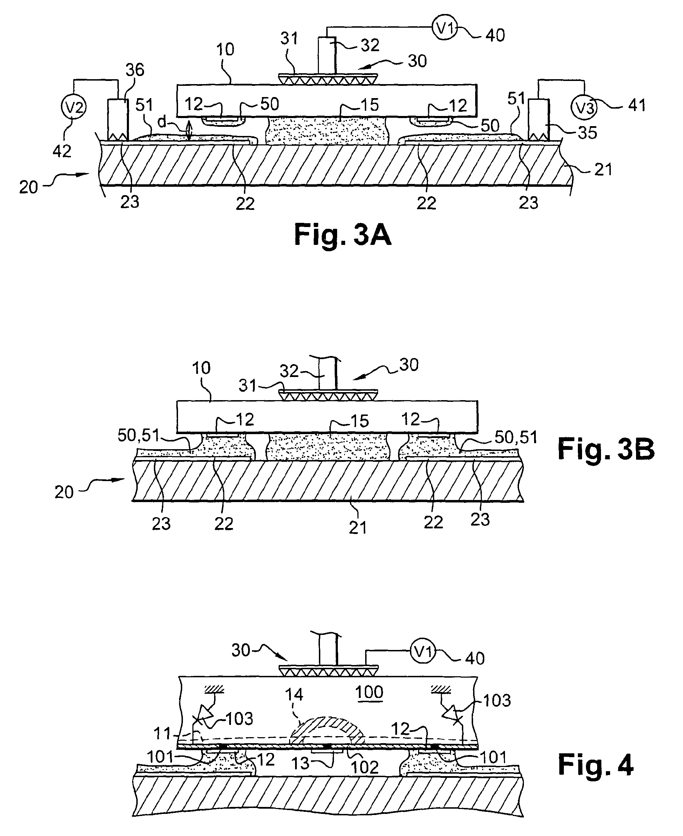

Comme indiqué plus haut, la présente invention prévoit de connecter électriquement une microplaquette de silicium à un support d'interconnexion en faisant croître une première couche de métal sur des plages de contact de la microplaquette, et une seconde couche de métal sur des plages de réception du support d'interconnexion, jusqu'à ce que les deux couches se rejoignent. L'étape de croissance des deux couches métalliques est faite par dépôt électrolytique de métal et est illustrée sur les figures 3A, 3B qui seront décrites plus loin. On décrira préalablement des étapes préparatoires qui précèdent l'étape de dépôt électrolytique.

La figure 2A représente une microplaquette de silicium 10 vue de dessus avant la mise en oeuvre du procédé selon l'invention. La face supérieure ou face active de la microplaquette 10 comporte une région de circuit intégré 11 implantée dans le silicium, et des plages de contact 12. Celles-ci sont généralement en aluminium et d'une faible épaisseur, généralement de 0,1 à 1 micromètre. Elles sont connectées à la région de circuit intégré 11 grâce à des orifices (non représentés) qui traversent une couche de protection (passivation) déposée à la surface de la microplaquette.

De préférence, les plages de contact 12 font l'objet d'un traitement de surface garantissant l'accrochage d'un métal au cours de l'étape de dépôt électrolytique. Ce traitement de surface comprend par exemple une désoxydation de l'aluminium ou le dépôt d'une couche d'accrochage de faible épaisseur, par exemple en Nickel, en Zinc-Nickel ou en Palladium. Il peut être réalisé quand la microplaquette est encore solidaire de la plaque de silicium ("wafer") dont elle est issue, avant la découpe de la plaque en microplaquettes individuelles. Cette étape de traitement préliminaire est donc sensiblement identique à l'étape de traitement qui précède la formation, par dépôt électrolytique d'un matériau de connexion, des excroissances ("bump") prévues par la technique flip-chip.

La figure 2B est une vue de dessus partielle d'un support d'interconnexion 20 destiné à recevoir la microplaquette 10. Le support d'interconnexion 20 comprend un substrat diélectrique 21, sur lequel ont été formées des plages conductrices ou plages de réception 22 destinées à recevoir les plages de contact 12 de la microplaquette, l'emplacement prévu pour les plages de contact 12 étant repéré par des traits pointillés 12'. Les plages 22 se prolongent sous la forme de pistes conductrices 23 qui sont destinées à relier la microplaquette à d'autres composants. Ces autres composants peuvent être d'autres microplaquettes de silicium qui seront connectées collectivement au support d'interconnexion au cours de l'étape de dépôt électrolytique de métal décrite plus loin, laquelle peut ainsi être appliquée simultanément à une pluralité de microplaquettes.

Le procédé de l'invention peut être mis en oeuvre avec deux types de supports d'interconnexion, que l'on désignera type "A" et type "B".

Le support d'interconnexion 20 est du type A s'il comprend des plages et des pistes conductrices totalement formées. Il s'agit par exemple d'un circuit imprimé comprenant un substrat en époxy et des pistes de cuivre réalisées par gravure d'une feuille de cuivre. Toutefois, un support d'interconnexion de type A au sens de l'invention peut également comprendre un substrat de type "flex", soit un substrat souple en un matériau polymère sur lequel ont été formées des plages et des pistes conductrices par dépôt électrolytique de métal.

Le support d'interconnexion 20 est du type B s'il comprend des plages et des pistes qui sont à l'état "embryonnaire", appelées généralement des "traces", qui forment seulement une couche d'accrochage pour un dépôt électrolytique de métal permettant d'obtenir des plages et des pistes totalement formées. Cette technique est généralement utilisée avec des substrats de type "flex" et les matériaux formant les traces sont généralement des encres conductrices déposées par jet d'encre. Les substrats de type "flex" sont couramment utilisés dans l'industrie et sont par exemple en polyéthylène. Ils sont généralement de faible épaisseur, par exemple 50 micromètres. Par ailleurs, les encres conductrices pour former les traces sont généralement des compositions polymères à charge métallique (cuivre, argent, or...) ou à charge de carbone (graphite).

Le support d'interconnexion, s'il est de type B, ne nécessite pas, en principe, d'étape préparatoire avant l'étape de dépôt électrolytique, les traces étant prévues à cet effet. Le support d'interconnexion, s'il est de type A, reçoit de préférence, comme les plages de contact de la microplaquette, un traitement de désoxydation ou une couche d'accrochage formant une barrière métallique compatible avec le dépôt électrolytique. De préférence, ce traitement est appliqué uniquement aux plages de réception 22 et les pistes conductrices 23 sont au contraire recouvertes d'une couche de protection (par exemple un vernis) s'opposant au dépôt de métal, sauf s'il est souhaité d'accroître l'épaisseur des pistes pour améliorer leur conductivité électrique.

La figure 3A illustre l'étape de connexion proprement dite, qui constitue l'étape essentielle du procédé selon l'invention.

La microplaquette 10 est tout d'abord agencée à l'envers, c'est-à-dire avec sa face active orientée vers le support d'interconnexion, et ses plages de contact 12 sont agencées sensiblement en regard des plages de réception 22 du support. L'agencement de la microplaquette est donc sensiblement la même que celui qui est prévu lors d'une connexion de type flip-chip, mais une distance d est conservée ici entre ses plages de contact 12 et les plages de réception 22 du support d'interconnexion. Cette distance d est de préférence de l'ordre de la dizaine à quelques dizaines de micromètres. Le maintien de la microplaquette 10 dans la position représentée est par exemple obtenu en interposant entre la microplaquette 10 et le substrat 21 une couche d'un matériau 15 électriquement isolant et de préférence adhésif, par exemple une colle polymère non conductrice.

L'ensemble est plongé dans un bain électrolytique (non représenté) comprenant des ions métalliques, par exemple un bain de cuivre, de nickel, voire un bain d'or. Une sonde 30 de polarisation électrique reliée à une source de potentiel 40 fournissant un potentiel électrique V1 de quelques Volt, est appliquée sur une face de la microplaquette 10, de préférence sa face arrière. La sonde 30 est en soi d'un type classique utilisé pour le dépôt électrolytique des excroissances de connexion flip-chip. Elle comprend par exemple une plaque de contact 31 équipée de pointes de forme pyramidale qui sont appliquées sur la face arrière de la microplaquette. La plaque de contact 31 est solidaire d'un tube conducteur (non représenté) relié à la source de potentiel 40, le tube étant monté coulissant dans un fourreau 32 comportant un ressort (non représenté) qui exerce sur la plaque de contact 31 une force de rappel en direction de la microplaquette 10.

De façon similaire, des sondes de polarisation 35, 36 à griffes ou à pinces ("clamps") reliées à des sources 41, 42 de potentiels électriques V2, V3 sont appliquées sur les pistes conductrices 23 (substrat de type A) ou sur les traces de pistes conductrices 23 (substrat de type B) du support d'interconnexion 20. Bien que cela n'apparaisse pas sur la représentation schématique de la figure 3A, les zones d'application des sondes de polarisation 35, 36 sont généralement situées à la périphérie du support d'interconnexion 20 et sont ensuite supprimées par découpe du substrat lorsque le processus de dépôt de métal est achevé.

Sous l'effet des potentiels électriques V1, V2, V3, des ions métallique s'agglomèrent sur les régions conductrices polarisées, à savoir sur les plages de contact 12 de la microplaquette 10 (le reste de la microplaquette 10 étant classiquement recouvert d'une couche de passivation) ainsi que sur les plages de réception 22 (support d'interconnexion de type A) ou sur les traces de plages de réception 22 et les traces de pistes conductrices 23 (support d'interconnexion de type B) .

On voit ainsi se former simultanément une première couche 50 de métal sur les plages de contact 12 et une seconde couche 51 de métal sur les plages de réception 22 ou sur les traces de plages de contact et les traces de pistes conductrices.

Le dépôt de métal par migration d'ions métalliques provoque l'apparition d'un courant d'électrolyse et la vitesse de croissance des couches métalliques 50, 51 est fonction des potentiels V1, V2, V3. Ces potentiels peuvent être identiques (dans ce cas une seule source de potentiel peut être utilisée). Toutefois, la prévision d'un potentiel V1 différent des potentiels V2, V3 peut permettre d'imposer des vitesses de croissance différentes aux couches 50, 51 afin de déposer plus de métal d'un côté ou de l'autre. Cela peut par exemple être souhaité lorsque le support d'interconnexion est de type B et que l'on souhaite déposer une épaisseur significative de métal sur les traces pour obtenir des plages de réception 22 et des pistes conductrices 23 de faible résistivité. La croissance des couches 50, 51 peut également être conduite de façon non simultanée, en appliquant les potentiels électriques à des instants différents.

Au terme du processus de croissance, les couches de métal 50, 51 se rejoignent dans les régions s'étendant entre les plages de contact 12 et les plages de réception 22, ainsi que cela est illustré sur la figure 3B. On obtient ainsi un contact électrique d'excellente qualité entre la microplaquette et le support d'interconnexion.

Le processus de dépôt de métal ne dure que quelques minutes et permet de déposer des couches conductrices 50, 51 d'une épaisseur d'une dizaine à quelques dizaines de micromètres chacune, préférentiellement de l'ordre de 10 à 15 micromètres.

L'avantage essentiel de ce procédé par rapport au procédé flip-chip est que les deux étapes classiques de formation des excroissances sur la microplaquette et de connexion de la microplaquette au support d'interconnexion sont regroupées en une seule étape de dépôt de métal et de connexion électrique. Dans le cas d'un support d'interconnexion de type B, ce sont trois étapes de processus qui sont habituellement réalisées à des moments différents, voire en des lieux différents, qui sont regroupées en une seule, à savoir l'étape de formation des plages de réception et des pistes conductrices du support d'interconnexion, l'étape de formation des excroissances sur la microplaquette et l'étape de connexion de la microplaquette au support d'interconnexion.

Le procédé de l'invention est naturellement susceptible de diverses variantes de réalisation. Notamment, le support d'interconnexion peut être à la fois de type A et de type B, c'est-à-dire présenter des pistes 23 totalement formées et des traces de plage de réception 22. Dans ce cas, les pistes 23 sont recouvertes d'une couche de protection, comme pour un substrat de type A.

L'invention peut également être mise en oeuvre au moyen d'un procédé de dépôt de métal ne nécessitant pas de polariser électriquement les zones à métalliser. Ce type de procédé, dit "electroless" (sans électricité) est également couramment utilisé dans l'industrie. Dans ce cas, les zones devant recevoir les couches de métal 50, 51 sont revêtues d'une couche d'accrochage ayant des propriétés d'électronégativité ou d'électropositivité compatible avec le métal déposé par électrolyse. Le processus de dépôt de métal reste par nature un dépôt galvanique, mais présente un temps de croissance plus faible déterminé par les affinités électroniques entre la couche d'accrochage et les ions métalliques en solution. Les couches de métal 50, 51 déposées sont par exemple en cuivre et les couches d'accrochage en cuivre ou en nickel. Le nickel et le cuivre se développent très bien avec la méthode "electroless", et permettent également la formation de couches d'une épaisseur de quelques dizaines de micromètres. Le processus est toutefois plus difficile à contrôler pour les couches de faible épaisseur, et comporte certains inconvénients (formation de précipités par exemple) qui sont compensés par une simplification des conditions de mise en oeuvre (absence de sondes de polarisation).

La présente invention est également susceptible de diverses applications. L'invention est notamment applicable à la fabrication de modules électroniques de faibles dimensions, notamment des modules électroniques sans contact destinés à être intégrés dans divers types d'objets portatifs sans contact, tels des cartes à puce sans contact, des badges électroniques sans contact, des étiquettes électroniques sans contact, etc.. Dans ce cas, la microplaquette 10 est par exemple un circuit intégré sans contact de type PICC ("Proximity Inductive Coupling Circuit") tel que décrit par la norme ISO 14443 (le terme "sans contact" désignant classiquement un circuit intégré prévu pour émettre et/ou recevoir des données au moyen d'une antenne). Les pistes 23 du support d'interconnexion, au lieu de relier la microplaquette à d'autres composants, forment une bobine d'antenne qui peut présenter une pluralité de spires coplanaires entourant la microplaquette 10. La microplaquette 10 peut également être un circuit intégré sans contact UHF et les pistes conductrices 23 former une antenne UHF sans enroulement.

La figure 4 est une vue dilatée de la figure 3A qui représente très schématiquement et en coupe la structure interne de la microplaquette de silicium 10. La microplaquette comprend un substrat 100 et la région de circuit intégré 11, implantée en face avant, s'étend sur une faible profondeur du substrat. Les plages de contact 12 sont reliées à la région active par des orifices métallisés 101 qui traversent une couche isolante 102 qui recouvre la région de circuit intégré 11. Les plages 12 sont également reliées au coeur du substrat 100 par l'intermédiaire de jonctions PN 103 qui forment des diodes antistatiques agencées dans le sens bloqué relativement à des charges électriques parasites qui pourraient s'accumuler sur les plages 12. De telles diodes empêchent donc des charges électriques parasites de pénétrer dans le coeur du substrat 100 et de provoquer des élévations de potentiel électrique (pouvant atteindre des milliers de Volt) qui endommageraient la région de circuit intégré 11. Un autre avantage des diodes antistatiques 103 est de permettre au potentiel V1 appliqué sur la face arrière de la microplaquette d'atteindre les plages de contact 12, puisque les diodes sont alors polarisées dans le sens passant.

Selon un aspect optionnel de l'invention, la microplaquette 10 comprend une ou plusieurs plages de contact 13 (une seule étant représentée) qui sont reliées à la région de circuit intégré 11 mais ne sont pas destinées à être connectées au support d'interconnexion. De telles plages de contact doivent au contraire être inaccessibles lorsque la microplaquette est montée sur le support d'interconnexion. Il s'agit généralement de plages de test utilisées par le fabricant pour conduire des séquences de test électrique permettant de rejeter les microplaquettes défectueuses au terme du processus de fabrication collective sur "wafer" de silicium.

Il est souhaitable que la couche de métal 50 ne se forme pas sur les plages de test 13 pendant la phase de dépôt électrolytique, car cela pourrait conduire à des connexions involontaires des plages 13 avec des conducteurs du support d'interconnexion.

A cet effet, un matériau protecteur peut être déposé sur les plages 13 mais cela implique une étape de traitement supplémentaire après l'étape de test. Or, il peut être également souhaité que toutes les étapes de fabrication y compris les étapes de préparation du dépôt électrolytique soient effectuées avant l'étape de test.

Comme autre solution, le matériau isolant 15 (fig. 3A) peut être utilisé pour recouvrir les plages 13 mais celui-ci est préférentiellement agencé au centre de la microplaquette et les plages de contact 13 sont préférentiellement situées à la périphérie de la microplaquette, à côté des plages de contact "normales" 12.

L'invention prévoit encore une autre solution, qui est de ne pas relier les plages 13 au coeur du substrat 100 avec des diodes antistatiques. Les plages de contact 13 sont au contraire isolées électriquement du coeur du substrat 100 par un caisson isolant 14, par exemple un caisson en oxyde de silicium. Dans ces conditions, le potentiel électrique V1 appliqué au substrat 100 ne se propage pas jusqu'au plages 13 et celles-ci n'attirent pas ou peu les ions métalliques, de sorte qu'aucun dépôt de métal d'épaisseur significative n'apparaît sur les plages 13.

Il peut être noté que l'absence de diodes antistatiques n'est pas problématique pour les plages 13 car celles-ci ne sont pas susceptibles de recevoir des charges électrostatiques importantes. En effet, les plages 13 sont utilisées dans des conditions de travail où les risques d'accumulation de charges électriques sont considérablement diminués par rapport aux conditions de fonctionnement dans lesquelles se trouve la microplaquette après avoir été montée sur le support d'interconnexion et lorsque celui-ci est intégré dans un équipement.

## Revendications

1. Procédé de connexion électrique d'une microplaquette (10) de semi-conducteur avec un support d'interconnexion (20), la microplaquette comprenant des plages de contact (12), le support d'interconnexion (20) comprenant un substrat (21) et des plages de réception (22), **caractérisé en ce qu'**il comprend une étape de croissance d'une première couche de métal (50) sur les plages de contact (12) de la microplaquette et une étape de croissance d'une seconde couche de métal (51) sur les plages de réception (22) du support d'interconnexion, par dépôt électrolytique de métal, jusqu'à ce que la première et la seconde couches de métal se rejoignent et forment un contact électrique reliant les plages de contact de la microplaquette et les plages de réception du support d'interconnexion.

2. Procédé selon la revendication 1, dans lequel l'étape de croissance de la première couche de métal (50) et l'étape de croissance de la seconde couche de métal (51) sont conduites simultanément.

3. Procédé selon l'une des revendications 1 et 2, comprenant les étapes suivantes :
- appliquer aux plages de contact (12) de la microplaquette un traitement les rendant compatibles avec le dépôt électrolytique de métal, et
- former les plages de réception (22) du support d'interconnexion avec un matériau compatible avec le dépôt électrolytique de métal ou appliquer aux plages de réception un traitement les rendant compatibles avec le dépôt électrolytique de métal.

4. Procédé selon l'une des revendications 1 à 3, dans lequel les couches de métal (50, 51) formées par dépôt électrolytique sont en un matériau compris dans le groupe comprenant le cuivre, le nickel et l'or.

5. Procédé selon l'une des revendications 1 à 4 dans lequel, avant le dépôt électrolytique de métal, les plages de réception (22) du support d'interconnexion comprennent seulement une trace d'un matériau compatible avec le dépôt électrolytique de métal, et les plages de réception ne sont entièrement formées qu'après croissance de la seconde couche de métal (51).

6. Procédé selon la revendication 5, dans lequel le support d'interconnexion comprend des pistes conductrices (23) dans le prolongement des plages de réception (22), et dans lequel, avant le dépôt électrolytique de métal, les pistes conductrices comprennent seulement une trace d'un matériau compatible avec le dépôt électrolytique de métal, et ne sont entièrement formées qu'après croissance de la seconde couche de métal (51).

7. Procédé selon l'une des revendications 5 et 6, dans lequel la trace de matériau compatible avec le dépôt électrolytique de métal comprend un matériau polymère.

8. Procédé selon l'une des revendications 1 à 7, dans lequel les plages de réception (22) du support d'interconnexion et les plages de contact (12) de la microplaquette sont portées à un potentiel électrique non nul (V1, V2, V3) pendant le dépôt électrolytique de métal.

9. Procédé selon l'une des revendications 1 à 8 dans lequel, pendant le dépôt électrolytique de métal, les plages de contact (12) de la microplaquette sont portées à un potentiel électrique (V1) en appliquant le potentiel électrique à un substrat semi-conducteur (100) de la microplaquette et en utilisant des jonctions PN antistatiques (103) reliant les plages de contact (12) au substrat semi-conducteur (100) pour propager le potentiel électrique jusqu'aux plages de contact.

10. Procédé selon la revendication 9, comprenant une étape consistant à prévoir dans la microplaquette des plages de contact (12) qui sont dépourvues de jonction antistatique (103) et sont isolées du substrat semi-conducteur (100) par un caisson (14) de matériau électriquement isolant, de sorte qu'aucun dépôt de métal d'épaisseur significative ne se produit sur de telles plages de contact pendant le dépôt électrolytique de métal.

11. Procédé selon l'une des revendications 1 à 10, dans lequel, pendant le dépôt électrolytique de métal, la microplaquette (10) est maintenue sur le support d'interconnexion par une couche de matériau isolant (15) qui ne recouvre pas les plages de contact (12) de la microplaquette devant recevoir la première couche de métal (50).
